(19) Europäisches Patentamt
European Patent Office
Office européen des brevets

(11) **EP 4 358 087 A1**

(12) **EUROPÄISCHE PATENTANMELDUNG**

(43) Veröffentlichungstag:
**24.04.2024  Patentblatt 2024/17**

(21) Anmeldenummer: 22202657.7

(22) Anmeldetag: **20.10.2022**

(51) Internationale Patentklassifikation (IPC):
**G11C 7/10** (2006.01)     **G06N 3/063** (2023.01)
**G11C 11/54** (2006.01)

(52) Gemeinsame Patentklassifikation (CPC):
**G11C 7/1006; G06N 3/065; G11C 11/54**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(71) Anmelder: Semron GmbH
**01067 Dresden (DE)**

(72) Erfinder:
• **Demasius, Kai-Uwe**
  **01324 Dresden (DE)**
• **Pozhidaev, Vadim**
  **72764 Reutlingen (DE)**

(74) Vertreter: **Lippert Stachow Patentanwälte**
**Rechtsanwälte**
**Partnerschaft mbB**
**Krenkelstraße 3**
**01309 Dresden (DE)**

(54) **ANORDNUNG EINER PULSWEITEN GESTEUERTEN VEKTOR-MATRIX MULTIPLIKATIONSEINHEIT MIT KAPAZITIVEN ELEMENTEN UND VERFAHREN ZU DESSEN ANSTEUERUNG**

(57)    Der Erfindung, die eine Anordnung einer pulsweiten gesteuerten Vektor-Matrix-Multiplikationseinheit und ein Verfahren zu deren Ansteuerung betrifft, bei der ein Eingangsblock mit den Wortleitungen einer Matrix aus nichtflüchtigen Speicherbauelementen verbunden ist, und Ausgangsblöcke aufweist, welche einen Verstärker mit invertierendem Eingang und einer rückgekoppelten Kapazität mit parallelen Schalter enthalten, liegt die Aufgabe zugrunde, die Energieeffizienz mit einem verbesserten analogen Komparator von dem Zweirampen Verfahren zu steigern. Dies wird dadurch gelöst, dass
- die nichtflüchtigen Speicherbauelemente aus einstellbaren Kondensatoren (10) bestehen

- und der Eingangsblock Schalter (11) enthält, welche einen Spannungsrampengenerator (12) mit den Wortleitungen (3) verbinden, wobei der Schalter von der Eingangspulslänge steuerbar gestaltet ist
- und der Verstärker im Ausgangsblock mit rückgekoppelter Kapazität, als nicht-invertierender Verstärker (7) zusammen mit den einstellbaren Kondensatoren (10) der Matrix fungiert und
- die Referenz für eine zweite Phase, welche mit dem invertierenden Eingang des Verstärkers verbunden ist, aus einem Referenzkondensator (13) mit einem angeschlossenen umgekehrten Spannungsrampengenerator (14) besteht.

**Fig. 1**

EP 4 358 087 A1

**Beschreibung**

In den letzten Jahren, gab es ein zunehmendes Interesse analoge Vektor-Matrix-Multiplikationen durchzuführen mittels Speicherzellen, welche einen Multiplikanden darstellen. Die Speicherzellen sind hierbei in Matrixform angeordnet und stellen die Koeffizienten dar und die Eingangswerte werden an die horizontalen Leitungen angelegt, welche die Wortleitungen sind. Die Akkumulationsoperation erfolgt meist unter Ausnutzung des Kirchhoffschen Gesetzes, indem die Ausgangsströme der Speicherzellen sich aufsummieren. Anwendungen solcher Anordnungen sind vor allem in der Berechnung von künstlichen neuronalen Netzen oder dem Lösen von Differentialgleichungen.

Eine Möglichkeit ist die Nutzung von nicht-volatilen Speichern, wie z.B. resistiven Speichern (e.g. Ielmini et al.: "In-memory computing with resistive switching devices". Nature Electronics, 2018). Hierbei wird die Multiplikation mit Hilfe des Ohmschen Gesetzes durchgeführt, indem beispielsweise eine Spannung an die Wortleitungen der Matrix angelegt wird und die summierten Ströme aus der Bitleitung der Matrix gemessen werden.

Die Vektor-Matrix Multiplikation wird mit diesem Ansatz im analogen durchgeführt und es ist eine Konvertierung von digitalen Daten in analoge Eingangssignale für die Wortleitungen und eine Konvertierung von analogen Ausgangssignale in digitale Daten an den Bitleitungen notwendig, damit die Multiplikationseinheit mit konventioneller digitaler Prozessierung kombiniert werden kann.

In Patent EP3523805B1 und Publikation Demasius et al.: "Energy-efficient memcapacitor devices for neuromorphic computing". Nature Electronics, 2021 wurden neben den gerade erwähnten resistiven nichtvolatilen Speichern auch kapazitive nicht-volatile Speicher vorgestellt. Diese beruhen darauf, dass die Kapazität eines Kondensators frei eingestellt werden kann und die Kapazität nicht volatil gespeichert werden kann. Kapazitive Bauelemente haben gegenüber resistiven Bauelementen den Vorteil, dass diese kaum einen statischen Stromverbrauch besitzen und ein besseres Signal-Rausch-Verhältnis haben. Somit kann bei selber Signalqualität im Vergleich zum resistiven eine geringere Auslesespannung genutzt werden, was auch mit einem geringeren dynamischen Energieverbrauch einhergeht.

Für die hierzu notwendigen Digital-Analog und Analog-Digital (ADCs) Wandler gibt es verschiedene Optionen: Parallele Umsetzer, Sukzessive-Approximations-Register (SAR) - ADCs oder integrierende Umsetzer. In analogen Vektor-Matrix Multiplizieren wird am häufigsten ein paralleler Umsetzer oder ein SAR ADC verwendet (Caselli et al.: "Memory Devices and A/D Interfaces: Design Tradeoffs in Mixed-Signal Accelerators for Machine Learning Applications". IEEE, 2022). Der parallele Umsetzer hat seinen Vorteil, wenn eine hohe Geschwindigkeit erfordert wird und der SAR ADC ist vorteilhaft, wenn Energieeffizienz im Vordergrund steht. Beide ADC typen haben jedoch den Nachteil, dass ein hoher Platzverbrauch nötig ist und im Falle von SAR ADC eine komplizierte digitale Kontroll-Logik. Für Matrizen mit analogen Speicherbauelementen sind die Bitleitungen jedoch recht dicht aneinandergereiht und um einen Vorteil gegenüber digitalen Schaltungen zu ermöglichen, ist es von Vorteil, wenn die an den Bitleitungen angeschlossenen ADC ebenfalls eine kompakte Bauweise haben. Dies ist vor allem wichtig vor dem Hintergrund, dass Design Regeln beim Design von integrierten Schaltkreisen eingehalten werden müssen (z.B. minimale Abstände von Transistoren und Metallleitungen) und diese Design Regeln werden bei einer dichten Aneinanderreihung schwieriger einzuhalten sein, je komplexer und größer die ADC Schaltung ist.

In US11409045B2 wird ein Rampen ADC benutzt im Zusammenhang mit resistiven Bauelementen. Hierbei wird der Ausgangstrom der Bitleitung aufintegriert US11409045B2 oder mit einem invertierenden Verstärker US2021271732A1 in eine Spannung konvertiert. Diese Spannung wird anschließend mit einem Rampensignal verglichen und mit einem analogen Komparator in eine Pulslänge umgewandelt. Die Pulslänge wird mit einem Zählwerk in ein binäres Signal umgewandelt.

ADCs nach dem Zweirampenverfahren haben eine Integrationsphase, bei der der Strom von der Bitleitung aufintegriert (erste Phase) wird und anschließend eine Deintegrationsphase (zweite Phase), bei der der Ladungszustand des Integrators gelöscht wird. Der Zeitraum bis der Integrator wieder zu der Ursprungsspannung zurückkehrt wird in eine Pulslänge mit einem Komparator umgewandelt und wieder gezählt. Eine Beispielhafte Ausführung mit Stromquellen für resistive nichtflüchtige Speicher befindet sich in der Anmeldung US2020234111A1. Bei zweirampen ADC besteht der Vorteil im Vergleich zu einrampen ADC, dass sich die Integrationskapazität herauskürzt und eine deutlich geringere Alterungs- und Temperaturabhängigkeit besteht. Diese Anmeldung erklärt jedoch nicht die Nutzung von kapazitiven nichtflüchtigen Speichern, welche den Vorteil eines deutlich verringerten Energieverbrauches haben, da diese nicht mehr in Form einer Stromquelle benutzt werden können. Da die Anmeldung diesem Patent am nächsten kommt, wird diese als Stand der Technik angenommen.

Der analoge Komparator bei Rampen ADC, kann beispielsweise eine weitere OPV Schaltung oder ein differentieller Verstärker sein, wie in Anmeldung US2020234111A1 geschildert. Diese hat jedoch den Nachteil, dass ein statischer Stromverbrauch nötig ist, und dieser ADC Typ keinen Energieeffizienzvorteil mehr besitzt. Eine andere Option wäre ein dynamischer Latch basierter Komparator, der jedoch bei einem z.B. einem 8 Bit Wert 256 mal schalten muss, was einen hohen dynamischen Energieverbrauch bedeutet. In der Publikation Jendernalik et al.: "An Ultra-Low-Energy Analog Comparator for A/D Converters in CMOS Image Sensors". Circuits Syst Signal Process, 2017 wurde ein energieeffizienter Komparator für Bildsensoren vorgestellt, welcher nur einen dynamischen Stromverbrauch zum Umschaltzeitpunkt besitzt. Hierzu wird ein Eingangstransistor benutzt, welcher abhängig von der Gate-Source Spannungsdifferenz einen Entladestrom für eine voraufgeladene Kapazität erzeugt und ein damit verbundener Ausgangstransistor umschaltet, sobald die Schwellspannung des Eingangstransistors überschritten wurde. Der Nachteil dieses Komparators ist die hohe Streuung der Eigenschaften des Eingangstransistors, in Abhängigkeit von Temperatur und Fertigungsbedingungen.

Aufgabe dieser Erfindung war es deswegen eine Architektur für eine analoge Vektor-Matrix-Multiplikationseinheit zu entwickeln, welche kapazitive nichtvolatile Speicherelemente verwendet und der Zweirampen ADC für diesen Zweck angepasst wird, sowie die Energieeffizienz mit einem verbesserten analogen Komparator von dem Zweirampen Verfahren gesteigert wird.

Erfindungsgemäß wird diese Aufgabe dadurch gelöst, dass die nichtflüchtigen Speicherbauelemente aus einstellbaren Kondensatoren bestehen und der Eingangsblock Schalter enthält, welche einen Spannungsrampengenerator mit den Wortleitungen verbinden, wobei der Schalter von der Eingangspulslänge steuerbar gestaltet ist und der Verstärker im Ausgangsblock mit rückgekoppelter Kapazität, als nicht-invertierender Verstärker zusammen mit den einstellbaren Kondensatoren der Matrix fungiert und die Kapazitäten der einstellbaren Kondensatoren aufsummiert werden, wobei die Ausgangsspannung des Verstärkers durch das Kapazitätsverhältnis bestimmt ist, und die Referenz für eine zweite Phase, welche mit dem invertierenden Eingang des Verstärkers verbunden ist, aus einem Referenzkondensator mit einem angeschlossenen umgekehrten Spannungsrampengenerator besteht.

Das heißt die einstellbaren Kondensatoren ($C_m$) sind parallel an den nicht-invertierenden Eingang des Verstärkers angeschlossen und die einstellbaren Kondensatoren bilden die Elemente der Matrix. Die einstellbaren Kondensatoren sind über die Wortleitungen mit Spannungsrampengeneratoren verbunden, welche durch die Eingangspulse gesteuert werden, sodass die Spannungsrampen eine unterschiedliche Länge haben an den einstellbaren Kondensatoren. Die Ausgangsspannung an den invertierenden Verstärkern wird damit über die Eingangsrampenspannung ($V_{ramp}$) und dem

Integrationskondensator ($C_{int}$) wie folgt determiniert:

$$V_{out} = -\frac{\sum C_m}{C_{int}} \cdot V_{ramp}$$

In einer zweiten Phase wird nach der ersten Eingangsrampe eine umgekehrte Rampe über einen Referenzkondensator die vorher generierte Ausgangsspannung wieder abgebaut mittels:

$$V_{out,2} = \frac{C_{ref}}{C_{int}} \cdot V_{ramp}$$

Die Dauer dieser zweiten Phase wird mit einem Komparator bestimmt und entspricht der Ausgangspulslänge.

In einer weiteren günstigen Ausführungsform besteht die Matrix aus differentiellen Elementen, mit jeweils positivem und negativem einstellbarem Kondensator, und die positiven und negativen einstellbaren Kondensatoren sind an eine gemeinsame Bitleitung verbunden und haben jeweils eine Wortleitung, welche im Eingangsblock jeweils einen Schalter haben, welche mit umgekehrten Spannungsrampen verbindend gestaltet sind und von derselben Eingangspulslänge steuerbar gestaltet sind.

Somit sind die Gewichte eines neuronalen Netzes in positive und negative Werte aufgespalten mit jeweils einer getrennten Wortleitung und es werden jeweils umgekehrte Spannungsrampen angeschlossen, sodass die Subtraktion in der Matrix bereits erfolgt, was ein Vorteil im Vergleich zum Stand der Technik ist, bei dem üblicherweise Differenzverstärker an zwei getrennten Bitleitung verwendet werden. In Formeln ausgedrückt heißt dies für die Ausgangsspannung des Verstärkers für die positive ($V_{ramp,+}$) und negative ($V_{ramp,-}$) Spannungsrampe, sowie den positiven ($C_{m,+}$) und negativen ($C_{m,-}$) einstellbaren Kondensatoren:

$$V_{out} = \frac{\sum C_{m,+}}{C_{int}} \cdot V_{ramp,+} - \frac{\sum C_{m,-}}{C_{int}} \cdot V_{ramp,-}$$

In einer Ausführungsform sind die umgekehrten Spannungsrampen an einem oder mehreren weiteren Schalter angeschlossen sind, welcher so gestaltet sind, dass die umgekehrten Spannungsrampen vertauscht werden können, wenn ein anderes Vorzeichen der Eingangspulslänge vorliegt.

Auf diese Weise kann beispielsweise sowohl die negative als auch positive Spannungsrampe mit dem positiven einstellbaren Kondensator verbunden sein oder umgekehrt mit dem negativen einstellbaren Kondensator. Hiermit wird zusammen mit den positiven und negativen einstellbaren Kondensatoren eine Vier-Quadranten Multiplikation in der Matrix ermöglicht.

In einer weiteren Ausführungsform, wird ein weiterer Versatzkondensator an den invertierenden Eingang des Verstärkers angeschlossen, welche mit einer weiteren Spannungsrampe verbindend gestaltet ist, sodass ein Versatz der Ausgangsspannung des Verstärkers erzielt wird.

Zweck dieser Anordnung ist, dass der Verstärker immer einen begrenzten Spannungsbereich hat und wenn dieser im unteren Spannungsbereich anfängt in Phase 1, würde dieser nicht in der Lage sein einen negativen Spannungsbereich abzudecken. Hierzu wird ein weiterer Versatzkondensator mit einer Spannungsrampe an den Eingang des Verstärkers angeschlossen. Hiermit wird eine Verschiebung der Anfangsausgangsspannung erreicht, sodass auch negative Spannungsbereiche abgedeckt werden können.

In einer weiteren Ausführungsform, wird der eine Komparatoreingang mit einem Kondensator verbunden, welcher weiterhin über einen Schalter mit einem Spannungsrampengenerator verbunden ist, wobei der Schalter von dem Komparatorausgang steuernd gestaltet ist, und der andere Komparatoreingang mit dem Ausgang des Verstärkers verbunden ist.

Ein typischer Komparator hat eine Offsetspannung und zudem hat der Verstärker typischerweise auch eine Offsetspannung, welche von der gewählten Verstärkertopologie abhängt. Diese kann mit der Temperatur aber auch über den Fabrikationsprozess hinweg schwanken. Vor allem bei der hier gewählten Komparatorstruktur (nächste Ausführungsform) wird die Schwellspannung des Eingangstransistors erheblich variieren. Eine Variation der Offsetspannungen würde zu einer veränderten Ausgangspulsweite des Komparators führen, da dieser zu unterschiedlichen Zeitpunkten schaltet. Mit dieser Ausführungsform wird eine Anordnung beschrieben, welche die Offsetspannung des Komparators und des Verstärkers auf einen Kondensator abtastet mittels einer angeschlossenen Spannungsrampe, sodass diese heraussubtrahiert wird.

In einer weiteren günstigen Ausführungsform besteht der Komparator aus einem Eingangstransistor, bei dem ein Eingang des Komparators mit dem Source Anschluss verbunden ist und der andere Eingang des Komparators mit dem Gate Anschluss des Eingangstransistors verbunden ist und der Drain Anschluss des Eingangstransistors mit einem Kondensator, welcher optional auch eine parasitäre Kapazität eines Transistors sein kann, und einem Gateanschluss eines weiteren Ausgangstransistors verbunden ist, wobei der Kondensator und der Ausgang des Ausgangstransistors so gestaltet sind, dass diese vorgeladen werden können, vor einer Komparationsphase.

Letztlich besteht der Komparator aus einem

Eingangstransistor, der einen Entladestrom generiert, welcher von der Differenzspannung der beiden Eingänge (Gate und Source Anschluss) abhängt. Dieser Entladestrom entlädt eine Kapazität, die an den Gateanschluss eines Ausgangstransistors angeschlossen ist, und ab einem bestimmten Punkt schaltet der Ausgangstransistor um, was dem Ende der Ausgangspulslänge entspricht. Dieser Zeitpunkt ist in etwa dann erreicht, wenn die Differenzspannung ($V_{GS}$) am Eingang die Schwellspannung ($V_T$) überschreitet:

$$V_{GS} \geq V_T$$

Der Vorteil dieses Komparators ist, dass nur ein dynamischer Energieverbrauch einmalig beim Umschaltzeitpunkt besteht. Dies unterscheidet den Komparator im Vergleich zu anderen dynamischen Komparatoren. Allerdings wird die Schwellspannung einer hohen Variation ausgesetzt sein, welche durch die vorherige Ausführungsform gelöst werden kann.

In einer weiteren Ausführungsform ist ein Zählwerk mit dem Ausgang des Komparators verbunden. Hiermit wird die Ausgangspulslänge in eine Binärzahl umgewandelt.

In einer weiteren Ausführungsform wird der Ausgang des Komparators mit einer Umsetzungstabelle verbunden, welche mit einem Taktgenerator steuernd gestaltet ist. Der Vorteil dieser Anordnung ist, dass im Vergleich zu einem binären Zählwerk, beliebige Zahlen in die Umsetzungstabelle geschrieben werden können und somit eventuelle nicht Linearitäten ausgeglichen werden können. Auch ist denkbar, dass die nichtlineare Aktivierungsfunktion, z.B. ReLU oder Sigmoid, in einer solchen Umsetzungstabelle abgebildet werden können.

Im Folgenden werden verfahrensseitige Ausführungsformen näher erläutert:

In einer günstigen Ausführungsform, wird in einer ersten Phase an den Bitleitungen der Matrix eine Spannungsrampe angelegt, wird, welche von der Eingangspulslänge gesteuert wird und die nichtflüchtigen einstellbaren Kondensatoren der Matrix entlang der Bitleitung aufsummiert werden, und in einer zweiten Phase über einen Referenzkondensator eine umgekehrte Spannungsrampe an den invertierenden Eingang des Verstärkers angelegt wird und der Komparator eine Pulslänge ausgibt, solange bis die Ausgangspannung des invertierenden Verstärkers wieder zur Ursprungsspannung zurückgekehrt ist. Letztlich wird die eingangsseitige Spannungsrampe mittels des folgenden Kapazitätsverhältnisses in eine Ausgangsspannungsrampe am Verstärker umgewandelt in einem ersten Schritt:

$$V_{out} = -\frac{\sum C_m}{C_{int}} \cdot V_{ramp}$$

In einer zweiten Phase danach wird diese Rampe wieder mit einem Referenzkondensator abgebaut:

$$V_{out,2} = \frac{C_{ref}}{C_{int}} \cdot V_{ramp}$$

Da die Steigung und der Endpunkt der Ausgangsspannungsrampe des Verstärkers variieren kann, je nach gespeicherter einstellbarer Kapazität und Eingangspulslänge, jedoch die Rampe der zweiten Phase immer gleichbleibt, kehrt der invertierende Verstärker zu seiner Ursprungsspannung zu unterschiedlichen Zeitpunkten zurück. Dieser Zeitpunkt wird mit dem Komparator ermittelt und in Form einer Pulslänge ausgegeben.

In einer weiteren verfahrensseitigen Ausführungsform werden die Wortleitungen der positiven und die Wortleitungen der negativen einstellbaren Kondensatoren mit umgekehrten Spannungsrampen geladen, jedoch die Spannungsrampen der Wortleitungen eines zusammengehörigen Matrixelements, bestehend aus einem positiven und negativen einstellbaren Kondensator mit derselben Eingangspulslänge gesteuert. In einer weiteren verfahrensseitigen Ausführungsform werden die umgekehrten Spannungsrampen vertauscht, sodass die umgekehrte Spannungsrampe an den Wortleitungen der positiven und negativen einstellbaren Kondensatoren anliegen, wenn das Eingangssignal ein anderes Vorzeichen hat. Dies ermöglicht eine Vierquadranten Multiplikation, da sowohl positive, als auch negative Eingangswerte nun möglich sind.

Hiermit werden die positiven und negativen Elemente der Matrix bereits in der Matrix selber subtrahiert, was vorteilhaft im Vergleich zu Umsetzungen mit einem Differenzverstärker ist, da dieser deutlich mehr Platz beansprucht.

In einer weiteren verfahrensseitigen Ausführungsform wird an dem einen Komparatoreingang eine Spannungsrampe angeschlossen, welche gleichzeitig einen Kondensator auflädt und diese Spannungsrampe wird unterbrochen, sobald der Komparatorausgang umschaltet und der Kondensator die abgetastete Versatzspannung speichert. Mit Hilfe dieses Verfahrens werden Temperatur - und Prozessschwankungen ausgeglichen.

In einer weiteren verfahrensseitigen Ausführungsform wird in einer ersten Phase der Kondensator und der Ausgang des Ausgangstransistors mit einem Rücksetzsignal vorgeladen und in einer zweiten Phase der Kondensator mit Hilfe des Eingangstransistors, welcher von der Spannungsdifferenz aus den beiden Eingängen angesteuert wird, entladen, und der Ausgangstransistor schaltet um, sobald die Schwellspannung des Eingangstransistors überschritten wird.

Diese Art der Nutzung des Komparators ermöglicht einen deutlich niedrigeren Energieverbrauch, da nur zum Umschaltzeitpunkt dynamische Energie verbraucht wird.

Im Folgenden werden günstige Ausführungsformen erläutert:

Fig. 1: Übersicht der Speichermatrix mit Eingangs - und Ausgangsblock
Fig. 2: Funktionsweise des Ausgangsblockes
Fig. 3: Versatzspannungsabtastung mit dem Komparator
Fig. 4: Schaltbild eines möglichen Komparators

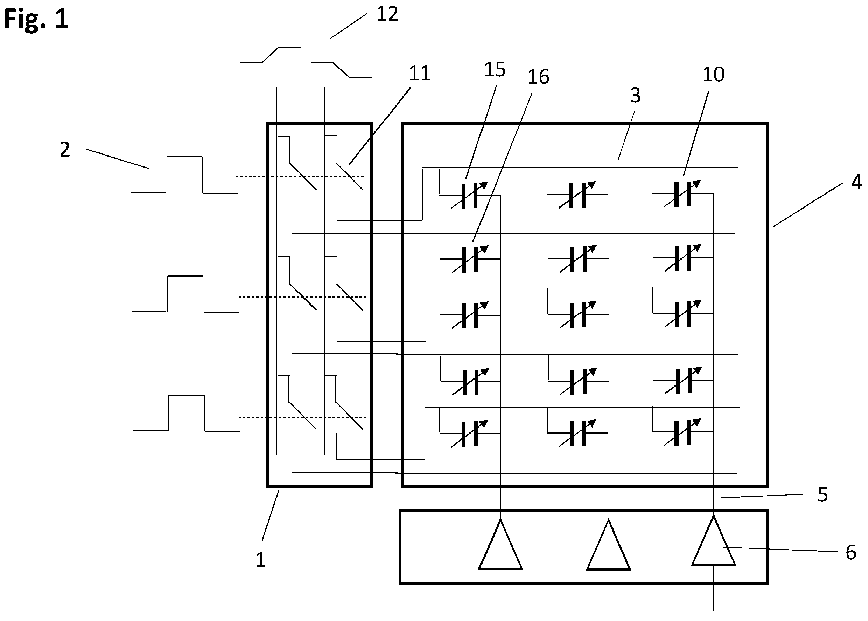

In Fig. 1 ist die Matrix mit nichtflüchtigen Speicherbauelementen (4) und angeschlossenem Eingangs- (1) und Ausgangsblock (6) dargestellt. Diese sind jeweils an die Wortleitungen (4) und Bitleitungen (5) angeschlossen. Innerhalb der Matrix (4) kommen einstellbare Kondensatoren (10) zum Einsatz, welche in positive (15) und negative (16) Kondensatoren aufgespalten sind. Die einstellbaren Kondensatoren (10) werden entlang der Bitleitung (5) aufsummiert. Die Wortleitungen werden mit Spannungsrampen (12) versehen, welche für positive (15) und negative (16) Kondensatoren einen umgekehrten Anstieg haben. Die Länge der Spannungsrampe wird über Schalter (11) im Eingangsblock und der Eingangspulslänge (2) gesteuert.

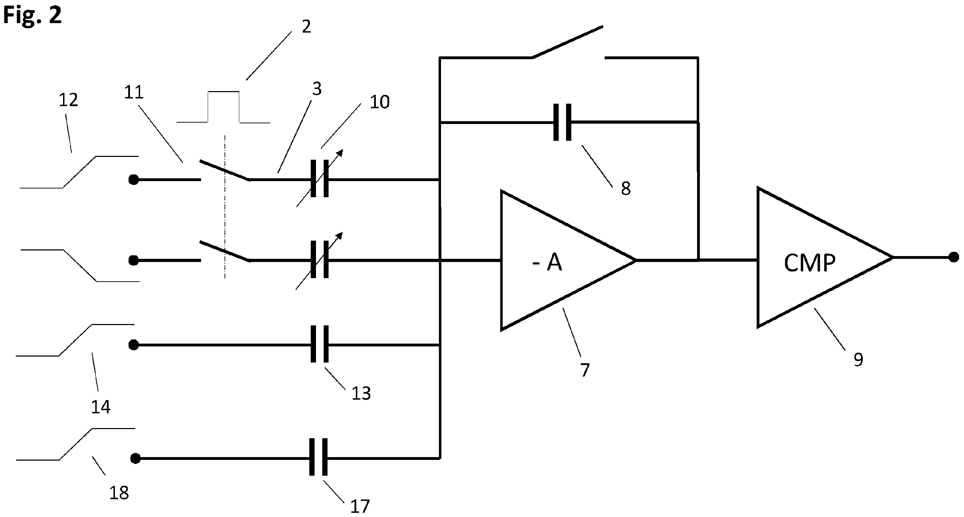

In Fig. 2 wird der Ausgangsblock näher erläutert, wobei zur Erklärung die positiven (15) und negativen (16) Kondensatoren mit den Schaltern (11) für den Eingangsblock eingefügt sind. Die einstellbaren Kondenstoren (10) summieren sich entlang der Bitleitung auf und bilden zusammen mit dem invertierenden Verstärker (7) und einer rückgekoppelten Kapazität (8) einen invertierenden Verstärker, dessen Ausgangsspannung von der Höhe der einstellbaren Kondensatoren (10) und der Eingangspulslänge (2) abhängt. In einer zweiten Phase wird einem weiteren Referenzkondensator (13) eine umgekehrte Spannungsrampe (14) appliziert, solange, bis die vorher aufgebaute Ausgangsspannung wieder abgebaut wurde und die Länge wird durch einen Komparator (9) als Pulslänge ausgegeben. Ebenfalls ist es möglich durch einen Versatzkondensator (17) und einer weiteren Spannungsrampe (18) eine Versatzspannung im Verstärker (7) einzuführen. Dies ist besonders dann sinnvoll, wenn sowohl positive, als auch negative Spannungen ausgegeben werden sollen.

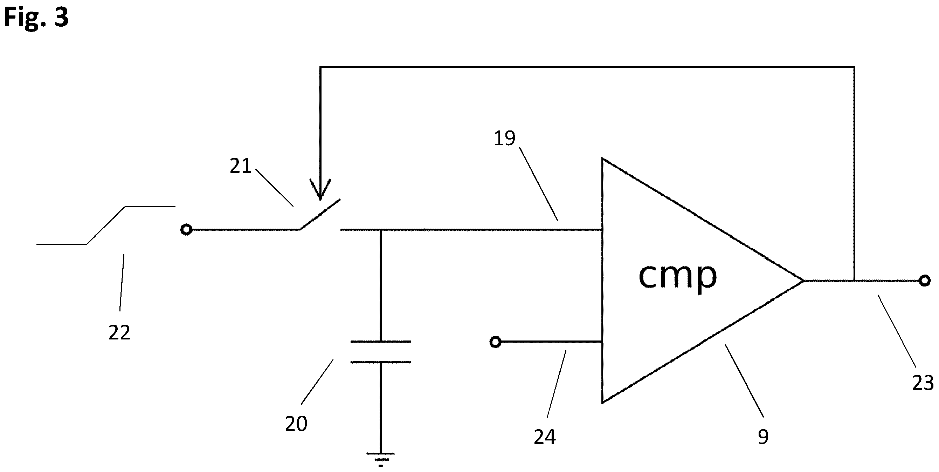

In Fig. 3 wird die Abtastung der Versatzspannung erläutert: Hierzu wird der eine Eingang (19) des Komparators mit einem Kondensator (20) verbunden, welcher durch eine Spannungsrampe (22) aufgeladen wird. Diese wird durch den Ausgang (23) des Komparators und einem Schalter (21) kontrolliert. Sobald der Komparator (9) umschaltet, ist der Versatzspannung an der Spannungsrampe (22) erreicht und wird auf dem Kondensator (20) gespeichert. Da die beiden Eingänge subtrahiert werden, wird die Versatzspannung von einfließen in die Komparationsphase, bei der Ausgangspuls generiert wird.

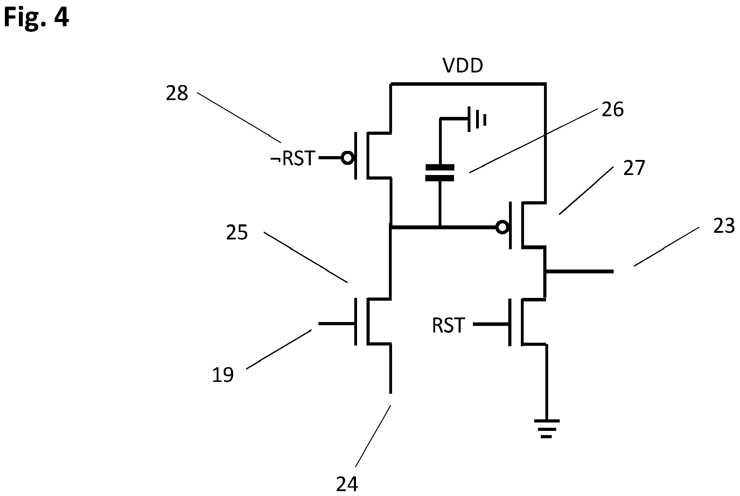

In Fig. 4 ist eine günstige Ausführung für einen Komparator gezeigt. Da übliche Komparatoren entweder einen statischen Stromverbrauch oder einen hohen dynamischen Stromverbrauch haben, kommt hier ein Komparator mit niedrigem dynamischen Energieverbrauch zum Einsatz, welcher nur einen Verbrauch beim Umschaltzeitpunkt besitzt (abgesehen von Leckströmen). Hierbei wird ein Kondensator (26) mit einem Rücksetzsignal (28) vorgeladen und anschließend über einen Eingangstransistor (25) entladen, wobei die Höhe der Entladung von der Differenz der Eingangssignale abhängt, welche an das Gate und dem Source-Anschluss des Eingangstransistors (25) anliegen. Der Ausgangstransistor (27) schaltet um, sobald die Schwellspannung des Eingangstransistors (25) überschritten wurde.

**Bezugszeichenliste**

1 - Eingangsblock
2 - Eingangspulse
3 - Wortleitungen
4 - Matrix aus nichtflüchtigen Speicherbauelementen
5 - Bitleitungen
6 - Ausgangsblöcke
7 - Verstärker
8 - rückgekoppelte Kapazität
9 - Komparator
10 - einstellbare Kondensatoren
11 - Schalter für Eingangsblock
12 - Spannungsrampen(-generator)
13 - Referenzkondensator
14 - umgekehrte Spannungsrampe für Referenz
15 - positiver einstellbarer Kondensator
16 - negativer einstellbarer Kondensator
17 - Versatzkondensator
18 - Spannungsrampe für Versatzkondensator
19 - erster Komparatoreingang
20 - Kondensator für Komparator
21 - Schalter für Komparator
22 - Spannungsrampengenerator für Komparator
23 - Komparatorausgang
24 - zweiter Komparatoreingang
25 - Eingangstransistor
26 - Kondensator im Komparator
27 - Ausgangstransistor
28 - Rücksetzsignal

**Patentansprüche**

1. Anordnung einer pulsweiten gesteuerten Vektor-Matrix Multiplikationseinheit, bei der ein Eingangsblock (1) Eingangswerte in Form von ein oder mehreren Eingangspulsen (2) erhält, und mit den Wortleitungen (3) einer Matrix aus nichtflüchtigen Speicherbauelementen (4) verbunden ist, und diese Eingangspulse in eine Spannung umwandelt und die Bitleitungen (5) der Matrix mit Ausgangsblöcken (6) verbunden sind, welche einen Verstärker (7) mit invertierenden Eingang und einer rückgekoppelten Kapazität (8) mit parallelen Schalter enthält zur Integration von Strömen und einer verbundenen Referenzstromquelle zur Deintegration in einer zweiten Phase und einen an dem Ausgang des Verstärkers verbundenen Komparators (9), **dadurch gekennzeichnet, dass**

  - die nichtflüchtigen Speicherbauelemente aus einstellbaren Kondensatoren (10) bestehen
  - und der Eingangsblock Schalter (11) enthält, welche einen Spannungsrampengenerator (12) mit den Wortleitungen (3) verbinden, wobei der Schalter von der Eingangspulslänge steuerbar gestaltet ist
  - und der Verstärker im Ausgangsblock mit rückgekoppelter Kapazität, als nicht-invertierender Verstärker (7) zusammen mit den einstellbaren Kondensatoren (10) der Matrix fungiert und die Kapazitäten der einstellbaren Kondensatoren (10) aufsummiert werden, wobei die Ausgangsspannung des Verstärkers durch das Kapazitätsverhältnis bestimmt ist,
  - und die Referenz für eine zweite Phase, welche mit dem invertierenden Eingang des Verstärkers verbunden ist, aus einem Referenzkondensator (13) mit einem angeschlossenen umgekehrten Spannungsrampengenerator (14) besteht.

2. Anordnung nach Anspruch 1, **dadurch gekennzeichnet, dass** differentielle Elemente der Matrix, mit jeweils positivem (15) und negativem (16) einstellbarem Kondensator, zum Einsatz kommen und die positiven und negativen einstellbaren Kondensatoren an eine gemeinsame Bitleitung (5) verbunden sind und jeweils eine Wortleitung (3) haben, welche im Eingangsblock jeweils einen Schalter (11) haben, welche mit umgekehrten Spannungsrampen (12) verbindend gestaltet sind und von derselben Eingangspulslänge (2) steuerbar gestaltet sind.

3. Anordnung nach Anspruch 2, **dadurch gekennzeichnet, dass** die umgekehrten Spannungsrampen (14) an einem oder mehreren weiteren Schalter angeschlossen sind, welcher so gestaltet sind, dass die umgekehrten Spannungsrampen (14) vertauscht werden können, wenn ein anderes Vorzeichen der Eingangspulslänge (2) vorliegt.

4. Anordnung nach einem der Ansprüche 1 bis 3, **dadurch gekennzeichnet, dass** ein weiterer Versatzkondensator (17) an den invertierenden Eingang des Verstärkers (7) angeschlossen wird, welche mit einer weiteren Spannungsrampe (18) verbindend gestaltet ist, sodass ein Versatz der Ausgangsspannung des Verstärkers erzielt wird.

5. Anordnung nach einem der Ansprüche 1 bis 4, **dadurch gekennzeichnet, dass** der eine Komparatoreingang (19) mit einem Kondensator (20) verbunden ist, welcher weiterhin über einen Schalter (21) mit einem Spannungsrampengenerator (22) verbunden ist, wobei der Schalter von dem Komparatorausgang (23) steuernd gestaltet ist, und der andere Komparatoreingang (24) mit dem Ausgang des Verstärkers (7) verbunden ist.

6. Anordnung nach einem der Ansprüche 1 bis 5, **dadurch gekennzeichnet, dass** der Komparator (9) aus einem Eingangstransistor (25) besteht, bei dem ein Eingang des Komparators mit dem Source Anschluss verbunden ist und der andere Eingang des Komparators mit dem Gate Anschluss des Eingangstransistors (25) verbunden ist und der Drain Anschluss des Eingangsstransistors (25) mit einem Kondensator (26), welcher optional auch eine parasitäre Kapazität eines Transistors sein kann, und einem Gateanschluss eines weiteren Ausgangstransistors (27) verbunden ist, wobei der Kondensator (26) und der Ausgang des Ausgangstransistors (27) so gestaltet sind, dass diese vorgeladen werden können, vor einer Komparationsphase.

7. Anordnung nach einem der Ansprüche 1 bis 6, **dadurch gekennzeichnet, dass** ein Zählwerk mit dem Ausgang des Komparators verbunden ist.

8. Anordnung nach einem der Ansprüche 1 bis 7, **dadurch gekennzeichnet, dass** der Ausgang des Komparators mit einer Umsetzungstabelle verbunden ist, welche mit einem Taktgenerator steuernd gestaltet ist.

9. Verfahren nach Anspruch 1, **dadurch gekennzeichnet, dass** in einer ersten Phase an den Bitleitungen (5) der Matrix eine Spannungsrampe (12) angelegt, wird, welche von der Eingangspulslänge (2) gesteuert wird und die nichtflüchtigen einstellbaren Kondensatoren (10) der Matrix entlang der Bitleitung (5) aufsummiert werden, und in einer zweiten Phase über einen Referenzkondensator (17) eine umgekehrte Spannungsrampe (12) an den invertierenden Eingang des Verstärkers (7) angelegt wird und der Komparator (9) eine Pulslänge ausgibt, solange bis die Ausgangspannung des invertierenden Verstärkers (7) wieder zur Ursprungsspannung zurückgekehrt ist.

10. Verfahren nach Anspruch 2, **dadurch gekennzeichnet, dass** die Wortleitungen (3) der positiven (15) und die Wortleitungen der negativen (16) einstellbaren Kondensatoren mit umgekehrten Spannungsrampen (12) geladen werden, jedoch die Spannungsrampen (12) der Wortleitungen (3) eines zusammengehörigen Matrixelements, bestehend aus einem positiven und negativen einstellbaren Kondensator mit derselben Eingangspulslänge (2) gesteuert werden.

11. Verfahren nach Anspruch 3, **dadurch gekennzeichnet, dass** die umgekehrten Spannungsrampen (12) vertauscht werden können, sodass die umgekehrte Spannungsrampe an den Wortleitungen der positiven und negativen einstellbaren Kondensatoren anliegen, wenn das Eingangssignal (2) ein anderes Vorzeichen hat.

12. Verfahren nach Anspruch 5, **dadurch gekennzeichnet, dass** an dem einen Komparatoreingang (19) eine Spannungsrampe (12) angeschlossen wird, welche gleichzeitig einen Kondensator (20) auflädt und diese Spannungsrampe (12) unterbrochen wird, sobald der Komparatorausgang (23) umschaltet und der Kondensator (20) die abgetastete Versatzspannung speichert.

13. Verfahren nach Anspruch 6, **dadurch gekennzeichnet, dass** in einer ersten Phase der Kondensator (26) und der Ausgang des Ausgangstransistors (27) mit einem Rücksetzsignal (28) vorgeladen werden und in einer zweiten Phase der Kondensator (26) mit Hilfe des Eingangstransistors (25), welcher von der Spannungsdifferenz aus den beiden Eingängen angesteuert wird, entladen wird, und der Ausgangstransistor (27) umschaltet, sobald die Schwellspannung des Eingangstransistors (25) überschritten wird

Fig. 1

**Fig. 2**

**Fig. 3**

**Fig. 4**

EP 4 358 087 A1

**Europäisches Patentamt**
**European Patent Office**
**Office européen des brevets**

# EUROPÄISCHER RECHERCHENBERICHT

Nummer der Anmeldung

**EP 22 20 2657**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | US 2022/027130 A1 (KASHMIRI SAYYED MAHDI [US] ET AL) 27. Januar 2022 (2022-01-27) | 1 | INV. G11C7/10 |
| A | * Absätze [0050] - [0244]; Abbildungen 1-49b * | 2-13 | G06N3/063 G11C11/54 |
| | ----- | | |
| Y | LUO YUAN-CHUN ET AL: "Design and Optimization of Non-Volatile Capacitive Crossbar Array for In-Memory Computing", IEEE TRANSACTIONS ON CIRCUITS AND SYSTEMS II: EXPRESS BRIEFS, IEEE, USA, Bd. 69, Nr. 3, 27. August 2021 (2021-08-27), Seiten 784-788, XP011903080, ISSN: 1549-7747, DOI: 10.1109/TCSII.2021.3108148 [gefunden am 2022-03-15] | 1 | |
| A | * Seiten 784-788; Abbildungen 1-8 * | 2-13 | |
| | ----- | | |

RECHERCHIERTE SACHGEBIETE (IPC)

G11C
G06N
G06F

Der vorliegende Recherchenbericht wurde für alle Patentansprüche erstellt

| Recherchenort | Abschlußdatum der Recherche | Prüfer |
|---|---|---|
| Den Haag | 6. April 2023 | Czarik, Damien |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

..............................................................................
& : Mitglied der gleichen Patentfamilie, übereinstimmendes Dokument

EPO FORM 1503 03.82 (P04C03)

# EP 4 358 087 A1

## ANHANG ZUM EUROPÄISCHEN RECHERCHENBERICHT
## ÜBER DIE EUROPÄISCHE PATENTANMELDUNG NR.

EP 22 20 2657

06-04-2023

| Im Recherchenbericht angeführtes Patentdokument | Datum der Veröffentlichung | Mitglied(er) der Patentfamilie | Datum der Veröffentlichung |
|---|---|---|---|
| US 2022027130 A1 | 27-01-2022 | CN 113990371 A | 28-01-2022 |
| | | DE 102021207661 A1 | 27-01-2022 |
| | | TW 202205113 A | 01-02-2022 |
| | | US 2022027130 A1 | 27-01-2022 |

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3523805 B1
- US 11409045 B2
- US 2021271732 A1
- US 2020234111 A1

**In der Beschreibung aufgeführte Nicht-Patentliteratur**

- **IELMINI et al.** In-memory computing with resistive switching devices. *Nature Electronics,* 2018
- **DEMASIUS et al.** Energy-efficient memcapacitor devices for neuromorphic computing. *Nature Electronics,* 2021
- **CASELLI et al.** Memory Devices and A/D Interfaces: Design Tradeoffs in Mixed-Signal Accelerators for Machine Learning Applications. IEEE, 2022
- **JENDERNALIK et al.** An Ultra-Low-Energy Analog Comparator for A/D Converters in CMOS Image Sensors. *Circuits Syst Signal Process,* 2017